# EUROPÄISCHE PATENTSCHRIFT

(11) **EP 1 179 738 B1**
(45) Veröffentlichungstag und Bekanntmachung des Hinweises auf die Patenterteilung: **02.03.2005**
(21) Anmeldenummer: 01000353.1
(22) Anmeldetag: 08.08.2001
(51) Int. Cl.: G01R 31/3183, G01R 31/3185

(54) **Anordnung zum Testen eines integrierten Schaltkreises**
Test arrangement for an integrated circuit
Agencement de test d'un circuit intégré

(30) Priorität: 10.08.2000 DE 10039004
(43) Veröffentlichungstag der Anmeldung: 13.02.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Hapke, Friedrich, c/o Philips Corp.Int.Prop. Gmbh, 52064, Aachen (DE)
(74) Vertreter: Volmer, Georg, Dipl.-Ing.

(56) Entgegenhaltungen:
- US-A- 4 901 259
- US-A- 5 377 197
- US-A- 5 572 535
- US-A- 5 883 809

## Beschreibung

Die Erfindung betrifft eine Anordnung zum Testen eines integrierten Schaltkreises mit einer kombinatorischen Logik, wobei die Anordnung einen Test des Verhaltens der kombinatorischen Logik im Vergleich zu einem Softwaremodell vornimmt, die das Soll-Verhalten des integrierten Schaltkreises emuliert.

Integrierte Schaltkreise wenden nach deren Fertigung üblicherweise getestet, d. h. es wird überprüft, ob die Schaltung in dem integrierten Schaltkreis wunschgemäß arbeitet. Ein hierfür bekanntes Verfahren ist das sogenannte Stuck-At-Fehlermodell. Bei diesem Fehler modell wird einzeln für jedes Element der kombinatorischen Logik überprüft, ob dessen Eingang und/oder Ausgang eine zu starke Koppelung mit dem positiven Versorgungspotential und/oder dem Bezugspotential aufweist. Dieses Prüfverfahren ist ein mehr oder weniger statisches Prüfverfahren, bei dem keine Flankenübergänge überprüft werden können. Diesem gravierenden Nachteil steht der Vorteil gegenüber, dass sogenannte kombinatorische Testmustergeneratoren eingesetzt werden können, welche in Aufbau und Arbeitsweise relativ einfach sind.

Bei den auf dem Stande der Technik bekannten Verfahren muss dann, wenn auch Flankenübergänge überprüft werden sollen, ein sogenannter sequentieller Testmustergenerator eingesetzt werden, welcher beispielsweise in zwei Testtakten die Zustände der kombinatorischen Logik überprüft und es somit auch gestattet, Flankenübergänge zu testen. Der gravierende Nachteil dieser Lösung besteht darin, dass solche sequentiellen Testmustergeneratoren sehr aufwendig und damit teuer sind. Ferner muss für diesen Test eine sehr große Anzahl von Testvektoren erzeugt werden, so dass auch der Test als solcher aufwendig ist. Ein Beispiel für ein Verfahren, das einen derartigen sequentiellen Testmustergenerator einsetzt, ist das aus der US 5,377,197 bekannte Verfahren. Es ist Aufgabe der Erfindung, ein Testverfahren anzugsben, welches mit einem kombinatorischen Testmustergenerator arbeiten kann, und welches darüber hinaus die Überprüfung von Flanken in der kombinatorischen Logik gestattet.

Diese Aufgabe ist erfindungsgemäß dadurch gelöst,
dass in der Testsoftware zwei identische Software-Modelle der zu prüfenden kombinatorischen Logik vorgesehen sind, wobei für Testzwecke ein Testmuster einem ersten dieser Software-Modelle zugeführt wird und deren Ausgangssignale auf ein zweites dieser Software-Modelle gekoppelt werden,
dass in dem integrierten Schaltkreis eine Testschaltung vorgesehen ist, welche in einem Testmodus in einem ersten Testtaktzyklus dem Eingang der kombinatorischen Logik des integrierten Schaltkreises ein Testmuster zuführt und das Ausgangssignal in einen Zwischenspeicher übernimmt und welche dieses in einem zweiten Testtaktzyklus auf den Eingang der kombinatorischen Logik rückkoppelt und wiederum das Ausgangssignal der kombinatorischen Logik in den Zwischenspeicher übernimmt,
und dass die Anordnung am Ende des zweiten Testtaktzyklus die in dem Zwischenspeicher stehenden Ergebnisse der kombinatorischen Logik des integrierten Schaltkreises mit den Ergebnissen des zweiten Software-Modells vergleicht.

Die in dem integrierten Schaltkreis vorgesehene und zu testende kombinatorische Logik, bei der es sich um verschiedenartige Schaltungselemente wie beispielsweise Gatter handeln kann und welche insbesondere keine speichernden Bauelemente aufweist, wird mittels eines Software-Modells emuliert. Dieses Softwarmodell ist in einem Computer lauffähig und ist so gestaltet, dass es das Verhalten, genauer das Soll-Verhalten, der kombinatorischen Logik emuliert, d h nachbildet. Ein wesentlicher Kerngedanke der erfindeischen Anordnung besteht darin, dieses Logikmodell der kombinatorischen Logik in doppelter Form vorzusehen. Es handelt sich also genau genommen um zwei identische, nacheinander geschaltete Logikmodelle der zu prüfenden kombinatorischen Logik. Wird dem ersten Softwaremodell ein Testmuster zugeführt, so werden dessen Ausgangssignale dem zweiten Softwaremodell als Eingangssignale zugeführt. Die Ausgangssignale des zweiten Softwaremodells werden in noch weiter zu erläuternder Weise zum Testen ausgewertet.

In dem eigentlich zu testenden integrierten Schaltkreis, also in der Hardware, ist eine Testschaltung vorgesehen, welche in einem Testmodus aktivierbar ist. Die Testschaltung weist einen Zwischenspeicher auf, welcher dazu dient, ein Testmuster zweimal hintereinander die kombinatorische Logik durchlaufen zu lassen. Dies geschieht dadurch, dass ein Testmuster, das in einem ersten Testtaktzyklus dem Eingang der kombinatorischen Logik des integrierten Schaltkreises zugeführt wird, am Ende diesesTesttaktes in den Zwischenspeicher übernommen wird. Mit einem zweiten Testtaktzyklus wird dieses Ergebnis wiederum dem Eingang der kombinatorischen Logik zugeführt und steht am Ende dieses zweiten Testtaktzyklus in dem Zwischenspeicher als Testergebnis zur Verfügung. Auch in der eigentlichen Hardware, also der kombinatorischen Logik in dem integrierten Schaltkreis, wird also ein Testmuster zweimal hintereinander durch eben diese Logik geführt und damit verändert.

Dadurch, dass in einem Testtaktzyklus sowohl in der Hardware wie auch in dem Softwaremodell ein Testmuster zweimal hintereinander durch die kombinatorische Logik geführt wird, kann deren dynamisches Verhalten, also das Flankenverhalten geprüft werden. In dem ersten Testtaktzyklus werden in der kombinatorischen Logik bestimmte Zustände erzeugt. Diese werden in den zweiten Testtaktzyklus durch neue Zustände ersetzt. Durch Überprüfen der Zustände am Ende des zweiten Testtaktzyklus kann somit überprüft werden, ob alle Elemente der kombinatorischen Logik den Wechsel von dem ersten Zustand des ersten Testtaktzyklus zu dem Zustand in dem zweiten Testtaktzyklus vollzogen haben.

Zur Überprüfung der Arbeitsweise des integrierten Schaltkreises bzw der in diesern vorgesehnen kombinatorischen Logik wird am Ende des zweiten Testtaktzyklus das Ergebnis des Zwischenspeichers in dem integrierten Schaltkreis mit dem Ergebnis der beiden hin tereinander geschalteten Softwaremodelle verglichen. Dieser Vergleich zeigt unmittelbar, ob die kombinatorische Logik in dem integrierten Schaltkreis das gewünschte Soll-Verhalten aufweist.

In der erfindungsgemäßen Anordnung zum Testen kann die Erzeugung der Testmuster mittels eines relativ einfachen kombinatorischen Testmustergenerators vorgenommen werden. Es entsteht somit ein recht geringer Testaufwand. Dennoch ist aufgrund der oben beschriebenen Testtaktzyklen bzw. des verdoppelten Softwaremodells ein Testen von Flanken in den Signalen der kombinatorischen Logik möglich.

Eine Ausgestaltung der Erfindung gemäß Anspruch 2. sieht vor, dass der Zwischenspeicher als Schieberegister ausgebildet ist, mittels dessen ein Einlesen und/oder Auslesen der Testmuster vorgenommen wind. Auf diese Weise kann der Zwischenspeicher sowohl Daten parallel aus der kombinatorischen Logik übernehmen bzw. diese an den Eingang der kombinatorischen Logik zurückführen, wie auch seriell Testmuster ein- oder auslesen.

Nachfolgend wird ein Ausführungbeispiel der Erfindung anhand der Zeichnung näher erläutert. Es zeigen:
Figur 1: eine schematische Darstellung einer zu testenden kombinatorischen Logik mit einer Testschaltung und
Figur 2: eine schematische Darstellung von Test-Software, in der das Softwaremodell für die Emulation der kombinatorischen Logik des integrierten Schaltkreises gemäß Figur 1 in verdoppelter Form vorliegt.

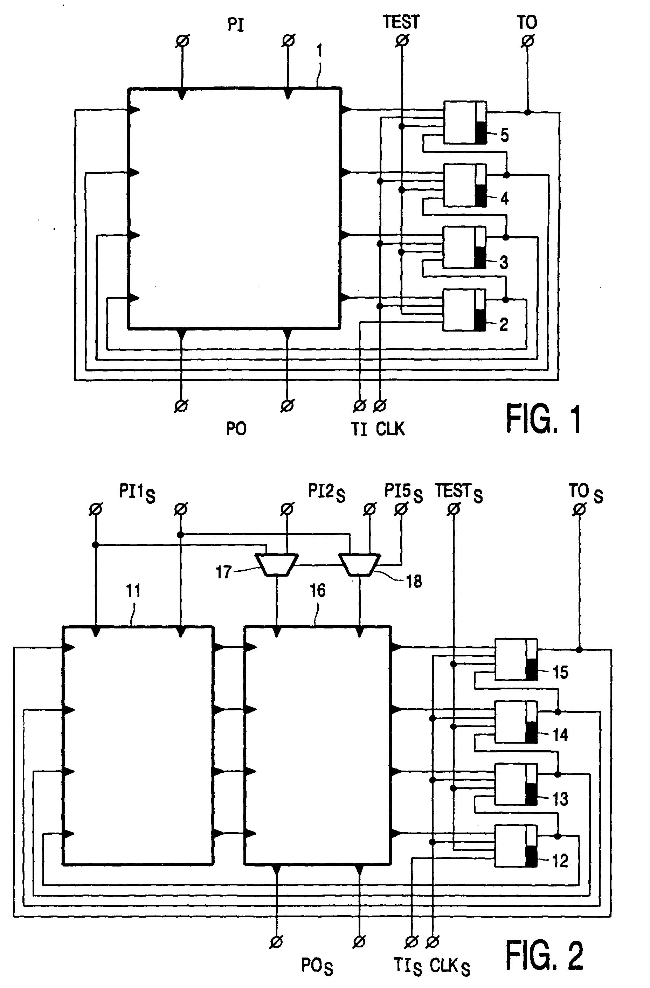

Eine schematische Darstellung gemäß Figur 1 zeigt Elemente eines integrierten Schaltkreises. In dem integrierten Schaltkreis soll insbesondere eine kombinatorische Logik 1 geprüft werden. Derartige Prüfprozesse sind nach Fertigung des integrierten Schaltkreises bzw. der kombinatorischen Logik sinnvoll, um das korrekte Verhalten der Logik zu überprüfen. Es handelt sich hierbei um die Hardware, also um den nach dern Fertigungsprozess entstandenen integrierten Schaltkreise der kombinatorischen Logik 1.

In dem integrierten Schaltkreis ist eine Testschaltung vorgesehen, welche aus Flip-Flops 2, 3, 4 und 5 aufgebaut ist. Diese Flip-Flops dienen sowohl als Zwischenspeicher zum Abspeichern der Testergebnisse der kombinatorischen Logik 1 wie auch zum Ein- und Auslesen von Testmustern.

Dazu sind erste Eingänge der Schieberegister 2, 3, 4 und 5 mit Ausgängen der kombinatorischen Logik 1 gekoppelt. Über diese ersten Eingänge werden Daten aus der kombinatoxischen Logik 1 beim Testen übernommen. Dies geschieht in Abhängigkeit eines Taktsignals CLK, welches jeweils einem Takteingang der Flip-Flops 2,3,4 und 5 zugeführt wird.

Auf jeweils dritte Eingänge der Schieberegister 2, 3, 4 und 5 ist ein Testsignal geführt, welche in der Figur mit TEST gekennzeichnet ist. Mittels dieses Testsignals kann die gesamte Schaltung in einen Testmodus versetzt werden, in welchern die Flip-Flops 2, 3, 4 und 5 auf einen vierten Eingang umgeschaltet werden und von diesem die Daten über nehmen. Das erste Flip-Flop 2 übernimmt dabei Daten von einem Testsignal TI, bei dem es sich um ein Testmuster handelt. Der Ausgang des Flip-Flops 2 ist auf den zweiten Eingang des Flip-Flops 3, der Ausgang des Flip-Flops 3 auf den zweiten Eingang des Flip-Flops 4 und der Ausgang des Flip-Flops 5 auf den zweiten Eingang des Flip-Flops 5 gekoppelt. Es entsteht somit bei aktiviertem Testsignal TEST ein Schieberegister. Dieses Schieberegister gestattet es, über den Eingang TI Daten seriell in die Kette der Flip-Flops 2, 3, 4 und 5, die in dieser Betriebsart ein Schieberegister bilden, einzulesen. In entsprechender Weise ist über diese Kette auch ein Auslesen von Daten möglich, wobei dieses Auslesen über den Ausgang des letzten Flip-Flops 5 vorgenommen wird. Diese Verbindung ist in der Figur mit TO gekennzeichnet und gestattet ein Auslesen eines in den Flip-Flops 2 bis 5 gespeicherten Testmusters.

Die kombinatorische Logik 1 weist ferner Eingänge PI und Ausgänge PO auf, bei denen es sich um die für die eigentliche Applikation der kombinatorischen Logik vorgesehen Einund Ausgänge handelt. Diese werden auch beim Testen aktiviert, insbesondere werden also den Eingängen PI auch beim Testen Daten zugeführt.

Die Ausgänge der Flip-Flops 2, 3, 4 und 5 sind jeweils auf Eingänge der kombinatorischen Logik 1 rückgekoppelt.

In einem Testvorgang der Schaltung geschieht gemäß der Erfindung folgendes:

Es wird zunächst über den Eingang TI bei aktiviertem Testsignal TEST ein Testmuster, in diesem Beispiel bestehend aus vier Bits, in die Flip-Flops 2, 3, 4 und 5 eingelesen. Dies geschieht in serieller Weise, da in diesem Zustand die Flip-Flops 2 bis 5 eine Art Schieberegister bilden. Anschließend wird zum Testen der kombinatorischen Logik ein Testtaktzyklus durchgeführt, in dessen Verlauf das in das Schieberegister, das aus den Flip-Flops 2 bis 5 gebildet wird, eingelesene Testmuster auf die Eingänge der kombinatorischen Logik 1 rückgekoppelt wird, die kombinatorische Logik 1 durchläuft und verändert wird Die engtsprechenden Daten werden am Ende dieses Testtaktzyklus in die Flip-Flops 2, 3, 4 und 5 parallel übernommen. Anschließend werden diese Daten, die an den Ausgängen der Flip-Flops 2 bis 5 anstehen in einem zweiten Testtaktzyklus wiederum die kombinatorische Logik 1 durchlaufen. Die hierbei wiederum veränderten Daten werden wieder in die Flip-Flops 2, 3,4 und 5 übernommen Schließlich werden diese Daten seriell über den Testausgang TO ausgelesen.

Im Ergebnis wird auf diese Weise ein Testmuster zweimal die kombinatorische Logik durchlaufen. In dem ersten Testtaktzyklus wenden die Elemente der kombinatorischen Logik bestimmte Zustände einnehmen. Durch den zweiten Durchlauf werden diese Zustände wiederum verändert. Durch Überprüfung der Zustände am Ende des zweiten Testtaktzyklus kann somit überprüft werden, ob die zu prüfenden Elemente der kombinatorischen Logik 1 den Übergang von dem Zustand am Ende des ersten Testtaktzyklus zu dem Soll-Zustand am Ende des zweiten Testtaktzyklus vollzogen haben.

Da für die beiden Testtaktzyklen nur ein Testvektor vorgesehen ist, der nacheinander zweimal die kombinatorische Logik durchläuft, und da dieser Testvektor am Ende des zweiten Testtaktzyklus auch nur einmal ausgelesen werden muss, kann ein sogenannter kombinatorischer Testmustergenerator eingsetzt werden, der relativ einfach ist.

Zur Überprüfung der Testergsbnisse ist eine Testsoftware vorgesehen, welche in Figur 1 in shematischer Form dargestellt ist. In der Testsoftware ist ein erstes Softwaremodell 11 vorgesehen, welches das Verhalten der kombinatorischen Logik der Hardware, also der kombinatorischen Logik 1 gemäß Figur 1, emuliert, d. h. nachbildet. In der Darstellung gemäß Figur 2, die die Software schematisiert, ist ferner ein zweites Softwaremodell 16 vorgeshen welches identisch dem ersten Softwaremodell 11 aufgebaut ist. Dieses zweite Softwaremodell emuliert also in gleicher Weise das Verhalten der kombinatorischen Logik 1 der Hardware gemäß Figur 1. Das zweite Softwaremodell 16 ist dem ersten Softwaremodell 11 nachgeschaltet, d h es übernimmt als Eingangssignale die Ausgangsägnale des ersten Softwaremodells 11.

Auch in dem Softwaremodell gemäß Figur 2 sind Flip-Flops 12,13,14 und 15 vorgesehen, welche in der Testsoftware entsprechend den Hardware-Flip-Flops der Schaltung gemäß Figur 1 verschaltet sind. Auch diese Flip-Flops 12, 13, 14 und 15 in den Softwaremodell gestatten also einerseits eine Übernahme von Testmustern aus den Softwaremodellen, ein Auslesen dieser Testmuster in ein Softwaremodell sowie ein Ein- und Auslesen von Testmustern über einen Testeingang TI_{S} und einen Testausgang TO_{S}.

Das erste Softwaremodell 11 weist primäre Eingängen PI1_{S} auf, die den Eingängen PI_{S} der kombinatorischen Logik 1 gemäß Figur 1 entsprechen. In ähnlicher Weise weist das zweite Softvaremodell 16 Einen Primäreingang PI2_{S} auf. Dem zweiten Softwaremodell 16 kann, umgeschaltet mittels Multiplexern 17 und 18 und eines diesen zugerührten Umschaltsignals PIS_{S} entweder das Eingangssignal PI1_{S} oder das Eingangssignal PI2_{S} zugeführt werden. In dem Softwaremodell dienen diese Signale natürlich nur zum Testen. Sie sind dennoch wesentliche da sich diese Signale in den Modellen der kombinatorischen Logik 11 und 16 mit den Testmustern überlagern. Das zweite Softwaremodell 16 weist ferner Primärausgänge PO_{S} auf.

Der oben anhand der Figur 1 für die Hardware beschriebene Testdurchlauf wird für die Software entsprechend Figur 2 in ähnlicher Weise vorgenommen. Es wird zunächst über den Testeingang TI_{S} ein Testmuster in die Flip-Flops 12, 13, 14 und 15 übernommen. Anschließend durchläuft dieses Testmuster die beiden Softwaremodelle 11 und 16. Das Ausgangssignal des zweiten Softwaremodells 16 wird dann wiederum in die Flip-Flops 12, 13, 14 und 15 übernommen und ist über den Testausgang TEST_{S} auslesbar.

Da in der Testsoftware gemäß Figur 2 die kombinatorische Logik als verdoppeltes Softwaremodell 11 und 16 vorgesehen ist, ist hier kein doppelter Durchlauf der Softwaremodelle erforderlich Vielmehr liefert das zweite Softwaremodell 16 die Soll-Ergebnisse nach den beiden Testtaktzyklen. Diese werden mit den oben in der Hardware gemäß Figur 1 in den beiden Testtaktzyklen erzeugten Ergebnissen, wie sie schließlich über den Testausgang TO der Schaltung gemäß Figur 1 auslesbar sind, verglichen.
Durch den zweimal hintereinander erfolgenden Durchlauf eines Testmusters durch die kombinatorische Logik 1 der Hardware gemäß Figur 1 und durch die Verdoppelung des Softwaremodells dieser kombinatorischen Logik in Figur 2 in Form der Softwaremodelle 11 und 16 ist ein Test möglich, bei dem ein einfacher kombinatorischer Testmustergenerator eingesetzt werden kann und bei dem dennoch ein Rückschluss auf das dynamische Verhalten insbesondere das Flankenverhalten von Schaltungaelementen der kombinatorischen Logik 1 gezogen werden kann. Dies ist dadurch möglich, dass in der kombinatorischen Logik 1 nacheinander zwei Zustände erzeugt werden, so dass der Übergang von dem ersten auf den zweiten Zustand überprüft werden kann. Dies entspricht der Überprüfung des dynamischen Verhaltens bzw. des Flankenverhaltens von Schaltungselementen der kombinatorischen Logik 1.

## Patentansprüche

1. Anordnung zum Testen eines integrierten Schaltkreises mit einer kombinatorischen Logik (1), wobei die Anordnung einen Test des Verhaltens der kombinatorischen Logik (1) im Vergleich zu einer Testsoftware vomimmt, die das Soll-Verhalten des integrierten Schaltkreis emuliert,
**dadurch gekennzeichnet,**
**dass** in der Testsoftware zwei identische Software-Modelle (11,16) der zu prüfenden kombinatorischen Logik (1) vorgesehen sind, wobei für Testzwecke ein Testmuster einem ersten (11) dieser Software-Modelle zugeführt wird und deren Ausgangssignale auf ein zweites (16) dieser Software-Modelle gekoppelt werden,
**dass** in dem integrierten Schaltkreis eine Testschaltung (2,3,4,5) vorgesehen ist, welche in einem Testmodus in einem ersten Testtaktzyklus dem Eingang der kombinatorischen Logik (1) des integrierten Schaltkreises ein Testmuster zuführt und das Ausgangssignal in einen Zwischenspeicher (2,3,4,5) übernimmt und welche dieses in einem zweiten Testtaktzyklus auf den Eingang der kombinatorischen Logik (1) rückkoppelt und wiederum das Ausgangssignal der kombinatorischen Logik (1) in den Zwischenspeicher (2,3,4,5) übernimmt,
und **dass** die Anordnung am Ende des zweiten Testtaktzyklus die in dem Zwischenspeicher (2,3,4,5) stehenden Ergebnisse der kombinatorischen Logik (1) des integrierten Schaltkreises mit den Ergebnissen des zweiten Software-Modells (16) vergleicht.

2. Anordnung nach Anspruch 1,
**dadurch gekennzeichnet,**
**dass** der Zwischenspeicher als Schieberegister (2,3,4,5) ausgebildet ist, mittels dessen ein Einlesen und/oder Auslesen der Testmuster vorgenommen wird.

## Claims

1. An arrangement for testing an integrated circuit comprising a combinational logic system (1), which arrangement performs a test of the behavior of the combinational logic system (1) in comparison with test software which emulates the nominal behavior of the integrated circuit,
**characterized in that**
the test software comprises two identical software models (11, 16) of the combinational logic system (1) to be tested, in which a test sample is applied for test purposes to a first (11) of these software models and whose output signals are coupled to a second (16) of these software models,
**in that** the integrated circuit comprises a test circuit (2, 3, 4, 5) which, in a test mode, applies a test sample in a first test clock cycle to the input of the combinational logic system (1) of the integrated circuit and takes over the output signal in a buffer memory (2, 3, 4, 5), and which feeds back this test sample in a second test clock cycle to the input of the combinational logic system (1) and again takes over the output signal of the combinational logic system (1) in the buffer memory (2, 3, 4, 5),
and **in that**, at the end of the second test clock cycle, the arrangement compares the results of the combinational logic system (1) of the integrated circuit in the buffer memory (2, 3, 4, 5) with the results ofthe second software model (16).

2. An arrangement as claimed in claim 1,
**characterized in that**
the buffer memory is constituted as a shift register (2, 3, 4, 5) by means of which the test samples are read and/or written.

## Revendications

1. Agencement de test d'un circuit intégré avec une logique combinatoire (1), dans lequel l'agencement effectue un test du comportement de la logique combinatoire (1) par comparaison avec un logiciel de test qui émule le comportement de consigne du circuit intégré,
**caractérisé en ce**
**que**, dans le logiciel de test, deux modèles logiciels (11, 16) identiques de la logique combinatoire (1) à tester sont prévus, un modèle de test étant amené à un premier (11) de ces modèles logiciels à des fins de test et ses signaux de sortie étant couplés à un deuxième (16) de ces modèles logiciels,
**que**, dans le circuit intégré, il est prévu un circuit de test (2,3,4,5) qui amène un modèle de test dans un mode de test dans un premier cycle de rythme de test à l'entrée de la logique combinatoire (1) du circuit intégré et prend en charge le signal de sortie dans une mémoire intermédiaire (2,3,4,5) et qui réinjecte celui-ci dans un deuxième cycle de rythme de test sur l'entrée de la logique combinatoire (1) et prend à nouveau en charge le signal de sortie de la logique combinatoire (1) dans la mémoire intermédiaire (2,3,4,5),
et **que** l'agencement à la fin du deuxième cycle de rythme de test compare les résultats, se trouvant la mémoire intermédiaire (2,3,4,5), de la logique combinatoire (1) du circuit intégré avec les résultats du deuxième modèle logiciel (16).

2. Agencement selon la revendication 1,
**caractérisé en ce**
**que** la mémoire intermédiaire est conçue comme un registre à décalage (2,3,4,5) à l'aide duquel un enregistrement et/ou une lecture des modèles de test sont effectués.
